## Europäisches Patentamt

## European Patent Office

## Office européen des brevets

(19)

(11) Veröffentlichungsnummer: **0 198 314**
**B1**

(12) **EUROPÄISCHE PATENTSCHRIFT**

(45) Veröffentlichungstag der Patentschrift:
15.03.89

(51) Int. Cl.⁴: **H02H 9/02, H03K 17/08**

(21) Anmeldenummer: 86104428.7

(22) Anmeldetag: 01.04.86

(54) Schutzdrossel für ein Stromrichterventil.

(30) Priorität: **16.04.85 DE 3513675**

(43) Veröffentlichungstag der Anmeldung:
**22.10.86 Patentblatt 86/43**

(45) Bekanntmachung des Hinweises auf die Patenterteilung:
**15.03.89 Patentblatt 89/11**

(84) Benannte Vertragsstaaten:
**AT CH DE GB LI**

(56) Entgegenhaltungen:
**DE-A- 1 613 876**
**US-A- 3 671 810**
**US-A- 4 152 637**

(73) Patentinhaber: **Siemens Aktiengesellschaft Berlin und München, Wittelsbacherplatz 2, D-8000 München 2(DE)**

(72) Erfinder: **Weigel, Wolf-Dieter, Dr.-Ing., Am Wiesengrund 9, D-8524 Kleinsendelbach(DE)**

## Beschreibung

Die Erfindung bezieht sich auf eine Schutzdrossel zur Begrenzung der Stromsteilheit beim Ein- und Ausschalten eines Stromrichterventils, insbesondere abschaltbaren Thyristors.

Aus der DE-A 1 613 876 ist eine Schutzdrossel bekannt, die zur Begrenzung von Überströmen in einzelnen Zweigen einer Stromrichterschaltung verwendet wird. Die Schutzdrossel arbeitet dabei im normalen Betrieb immer im gesättigten Bereich, so daß sie im normalen Betrieb praktisch keine Wirkung hat. Erst bei Überströmen kommt sie in ihren aktiven Bereich (Entsättigung) und begrenzt so den weiteren Stromanstieg.

Ähnlich wirkende Schutzdrosseln sind aus der US-A 4 152 637 und US-A 3 671 810 bekannt. Auch diese Schutzdrosseln dienen nur zur Begrenzung von Überströmen und haben beim Ein- und Ausschalten der Ventile auf die Stromsteilheit keinen Einfluß.

In Stromrichterschaltungen werden häufig nichtlineare, sättigbare, nicht vormagnetisierbare Schutzdrosseln zur Begrenzung der Stromsteilheit beim Ein- und Ausschalten der Ventile verwendet (PCI '81 PROCEEDINGS "NOVEL SOFT MAGNETIC CORE MATERIALS AND CORES FOR REACTORS IN THYRISTOR PROTECTION AND TURN-OFF CIRCUITS" G. Hinz, VACCUMSCHMELZE GmbH, Hanau, Deutschland). Bei selbstgeführten Stromrichterschaltungen, vor allem mit abschaltbaren Elementen, z.B. GTO-Thyristoren und -Transistoren, führt die Induktivität dieser Drosseln zu hohen unerwünschten Überladungen der Beschaltungskreise und damit zu einer zusätzlichen Beanspruchung der Halbleiter, weil die Stromübernahme durch symmetrisch wirkende Schutzdrosseln verzögert wird.

Bisher hat man zur Vermeidung unerwünschter Überladungen die Beschaltungselemente (Widerstände, Kondensatoren) entsprechend überdimensioniert oder unsymmetrische Kernbeschaltungen verwendet. Bei letzteren müssen hohe Totzeiten in Kauf genommen werden.

Der Erfindung liegt die Aufgabe zugrunde, eine Schutzdrossel zur Begrenzung der Stromsteilheit beim Ein- und Ausschalten eines Stromrichterventils anzugeben, bei der eine Überdimensionierung der Beschaltungselemente und unerwünschte Nebeneffekte vermieden werden.

Diese Aufgabe wird bei Schutzdrosseln der eingangs genannten Art erfindungsgemäß durch die Lehre des Anspruchs 1 gelöst; vorteilhafte Ausgestaltungen der Erfindung sind jeweils Gegenstand der Unteransprüche.

Durch die erfindungsgemäße Maßnahme wird eine von der Richtung des Laststromes abhängige Charakteristik erreicht, derart, daß die Schutzdrossel z.B. zwar den Anstieg eines Vorwärtsstromes in dem den Betriebsstrom schaltenden Abschalt-Thyristor begrenzt aber eine spontane Übernahme eines Stromes in Rückwärtsrichtung erlaubt. Auch die umgekehrte, z.B. für den Freilaufkreis mit einer Freilaufdiode vorteilhafte Charakteristik, nämlich ein spontaner Anstieg eines Vorwärtsstromes und eine verzögerte Übernahme eines Rückwärtsstromes, ist dabei in einfacher Weise möglich, indem die Drossel einfach in die umgekehrte Sättigungseinrichtung vormagnetisiert wird. Bei der Auslegung der Ventilbeschaltung braucht eine störende Wirkung wie bei symmetrischen Schutzdrosseln nicht mehr berücksichtigt werden; dadurch ergeben sich kleinere Verluste und ein kleinerer Raumbedarf. Gegenüber der unsymmetrischen Kernbeschaltung werden erhöhte Totzeiten und auch erhöhte Verluste vermieden.

Gemäß einer vorteilhaften Ausgestaltung der Erfindung ist vorgesehen, daß die Mittel zur Vormagnetisierung eine Einrichtung zum Zuschalten, Abschalten, Umschalten und/oder kontinuierlichen Einstellen oder Vormagnetisierung enthalten; dadurch läßt sich die von der Laststromrichtung abhängige Wirkung der Schutzdrossel je nach Betriebszustand einstellen. Diese Eigenschaft ist insbesondere von Vorteil für die Schaltungen, bei denen die Rolle von Hauptzweig und Freilaufzweig je nach Betriebszustand vertauscht wird. Zweckmäßigerweise ist dabei die Einrichtung zum kontinuierlichen Einstellen der Vormagnetisierung über einen Transformator an die Steuerwicklungen angekoppelt.

In der Zeichnung sind zwei Ausführungsbeispiele der Erfindung schematisch dargestellt; darin zeigen:

Fig. 1 einen Gleichstromsteller mit einem abschaltbaren Thyristor (GTO-Thyristor),

Fig. 2 die magnetische Kennlinie einer bekannten Schutzdrossel ohne Vormagnetisierung,

Fig. 3 die magnetische Kennlinie einer Schutzdrossel mit positiver Vormagnetisierung,

Fig. 4 die magnetische Kennlinie einer Schutzdrossel mit negativer Vormagnetisierung und

Fig. 5 einen Pulsstromrichter zum Gleich- und Wechselrichten.

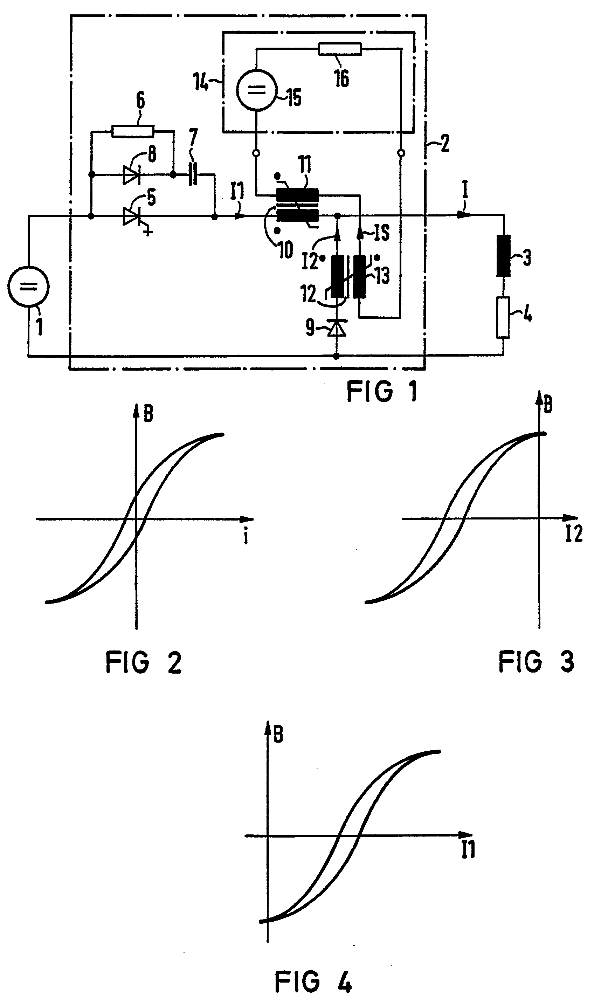

In Fig. 1 ist mit 1 eine Gleichspannungsquelle bezeichnet, die über einen Gleichstromsteller 2 und eine Glättungsdrossel 3 einen Gleichstromverbraucher 4 speist. Wenn der Abschalt-Thyristor 5 abgeschaltet wird, erlaubt die gemäß Fig. 3 vormagnetisierte Drossel 12 einen ungehinderten Anstieg des Stromes 12 und damit eine ungehinderte Übernahme des Laststromes 1. Ohne Vormagnetisierung würde die Drossel 12 für ihre Stufenzeit eine Lastübernahme nicht zulassen, so daß der Laststrom den Beschaltungskondensator 7 überladen würde.

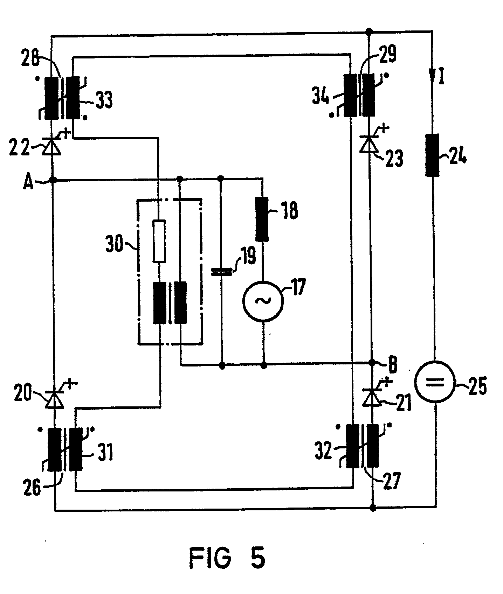

Bei dem in Fig. 5 gezeigten Pulsumrichter handelt es sich um eine Einrichtung zum Gleich- und Wechselrichten mit weitgehend sinusförmigen Größen auf der Wechselstromseite. An eine Wechselspannungsquelle 17 ist über ein Filter, bestehend aus der Drosselspule 18 und einem Kondensator 19, eine Einphasenbrückenschaltung, bestehend aus vier abschaltbaren Ventilen 20–23 angeschlossen, die eine Last, dargestellt durch eine Induktivität 24 und eine Gleichspannungsquelle 25, speist. Die abschaltbaren Ventile 20–23 liegen jeweils in Reihe mit einer Schutzdrossel 26–29, die wiederum jeweils magnetisch mit je einer Steuerwicklung zur Vormagnetisierung der zugehörigen Schutzdrossel 26–29 gekoppelt sind. Der Energiefluß ist dabei sowohl von der Wechselstromseite auf die Gleichstromseite als auch umgekehrt möglich. Die im Pulsbetrieb arbeitenden Ventile 20–23 erlauben einen praktisch sinusförmigen Netzbetrieb (siehe DE-Patent 2 646 745).

Je nach Polarität der Netz-Wechselspannung vertauschen die Ventile 20–23 ihre Rolle als Hauptventil oder Freilaufventil. Bei positiver Netzspannungshalbwelle, d.h. wenn die Klemme A positiv gegen die Klemme B ist, bildet das Ventil 23 das Freilaufventil zum Hauptventil 22. Überladungen in der hier nicht gezeigten Thyristorbeschaltung werden vermieden, indem der Laststrom 1 vom Ventil 23 ohne Behinderung durch die Schutzdrossel 29 übernommen werden kann. Dies ist möglich, da die Schutzdrossel 29 bei der vorgegebenen Netzpolarität entsprechend Fig. 3 vormagnetisiert wird. Als Mittel, durch die der Magnetkreis der Schutzdrossel 29 bis zum Beginn der Sättigung vormagnetisierbar ist, dienen eine Steuerwicklung 34 und eine Einrichtung zum kontinuierlichen Einstellen (Umpolen) der Vormagnetisierung.

Bei der Kommutierung vom Freilaufventil 23 auf das abschaltbare Ventil 22 begrenzt die Schutzdrossel 28 den Stromanstieg im Ventil 22 und die Schutzdrossel 29 verhindert einen Anstieg des Rückstromes im Freilaufventil 23. Dies ist dadurch möglich, daß die Schutzdrossel 28 entsprechend Fig. 4 und die Schutzdrossel 29 entsprechend Fig. 3 vormagnetisiert wird.

Bei negativer Netzspannungshallwelle stellt das Ventil 22 das Freilaufventil zum abschaltbaren Ventil 23 dar. Um die gleichen Verhältnisse wie oben beschrieben herzustellen, werden bei dieser Netzspannungspolarität die Schutzdrossel 28 entsprechend Fig. 3 und die Schutzdrossel 29 entsprechend Fig. 4 vormagnetisiert.

Für die Ventile 20, 21 der unteren Brückenhälfte, die abwechselnd mit den Ventilen 22, 23 gepulst werden, gelten analoge Verhältnisse.

Die von der Netzspannungspolarität abhängige Umschaltung der Vormagnetisierung der Schutzdrosseln 26–29 erfolgt mit einer Einrichtung zum kontinuierlichen Einstellen (Umpolen) der Vormagnetisierung. Im einfachsten Fall dient dazu eine Ankopplung über einen Transformator 30, dessen Primärwicklung an die Klemmen A und B angeschlossen ist.

Die Erfindung ist nicht auf die vorgenannten Ausführungsbeispiele beschränkt; weitere Anwendungen der Erfindung sind in Wechselrichterschaltungen mit eingeprägtem Strom und eingeprägter Spannung möglich.

## Patentansprüche

1. Schutzdrossel zur Begrenzung der Stromsteilheit beim Ein- und Ausschalten eines Stromrichterventils (5; 20–23), insbesondere abschaltbaren Thyristors, wobei Mittel (15, 16 bzw. 30) vorgesehen sind, durch die der Magnetkreis der Schutzdrossel oder einer Mehrzahl von Schutzdrosseln (10, 12 bzw. 26–29) mittels jeweils einer an die Schutzdrosseln (10, 12 bzw. 26–29) magnetisch angekoppelten Steuerwicklung (11, 13 bzw. 31–34) vormagnetisierbar ist, dadurch gekennzeichnet, daß der Magnetkreis bis zum Beginn der Sättigung in der Weise vormagnetisierbar ist, daß der Strom in Vorwärtsrichtung begrenzt steil und in Rückwärtsrichtung unbegrenzt steil ansteigt oder bei umgekehrter Vorwärtsmagnetisierung unbegrenzt steil und in Rückwärtsrichtung begrenzt steil ansteigt.

2. Schutzdrossel nach Anspruch 1, dadurch gekennzeichnet, daß die Mittel zur Vormagnetisierung eine Einrichtung zum Zuschalten, Abschalten, Umschalten und/oder kontinuierlichen Einstellen der Vormagnetisierung enthalten.

3. Schutzdrossel nach Anspruch 2, dadurch gekennzeichnet, daß die Einrichtung zum kontinuierlichen Einstellen der Vormagnetisierung über einen Transformator (30) an die Steuerwicklungen (31–34) angekoppelt ist.

## Claims

1. Protective choke for the limitation of the rate of current rise when switching on and off a rectifier (5; 20–23), more particularly a disconnectible thyristor, there being provided means (15, 16 or 30) through which the magnetic circuit of the protective choke or a plurality of protective chokes (10, 12 or 26–29) can be premagnetized by means of, in each case, a control winding (11, 13 or 31–34 magnetically coupled to the protective chokes (10, 12 or 26–29), characterised in that the magnetic circuit can be premagnetized up to the start of saturation such that the current rises with limited rate of rise in the forward direction and with unlimited rate of rise in the reverse direction or in the case of reversed premagnetization rises with unlimited rate cf rise in the forward direction and with limited rate of rise in the reverse direction.

2. Protective choke according to claim 1, characterised in that the means for premagnetization comprise a device for switching-in, switching-off, switching-over and/or continuous adjustment of the premagnetization.

3. Protective choke according to claim 2, characterised in that the device for continuous adjustment of the premagnetization is coupled by way of a transformer (30) to the control windings (31–34).

## Revendications

1. Bobine de protection servant à limiter la pente du courant lors du branchement et du débranchement d'une valve de redressement de courant (5; 20–23), notamment d'un thyristor pouvant être commuté à l'ouverture, des moyens (15, 16 ou 30) étant prévus, à l'aide desquels le circuit magnétique de la bobine de protection (10, 12, 26–29) peut être préaimanté au moyen d'un enroulement respectif de commande (11, 13 ou 31–34) couplé magnétiquement aux bobines de protection (10, 12 ou 26–29), caractérisée par le fait que le circuit magnétique peut être préaimanté jusqu'au début de la saturation de telle manière que le courant augmente avec une pente limitée dans le sens direct et augmente avec une pente illimitée dans le sens inverse ou bien, dans le cas d'une préaimantation inverse, augmente avec une pente illimitée dans le sens direct et augemente avec une pente limitée dans le sens inverse.

2. Bobine de protection selon la revendication 1, caractérisée en ce que les moyens servant à réaliser la préaimantation contiennent un dispositif pour brancher, débrancher, commuter et/ou régler de façon continue la préaimantation.

3. Bobine de protection suivant la revendication 2, caractérisée par le fait que le dispositif servant à régler de façon continue la préaimantation est couplé aux enroulements de commande (31–34) par l'intermédiaire d'un transformateur (30).

FIG 1

FIG 2

FIG 3

FIG 4

FIG 5